# EUROPEAN PATENT SPECIFICATION

(11) **EP 0 596 075 B1**
(45) Date of publication and mention of the grant of the patent: **22.08.2001**
(21) Application number: 93911250.4
(22) Date of filing: 05.05.1993
(51) Int. Cl.: H01L 21/18, H05K 7/00, H05K 1/00, H05K 1/14, H01L 25/065, H01L 23/48

(54) **NON-CONDUCTIVE END LAYER FOR INTEGRATED STACK OF IC CHIPS**
NICHTLEITENDE RANDSCHICHT FÜR INTEGRIERTEN STAPEL VON IC CHIPS
COUCHE TERMINALE NON CONDUCTRICE POUR PILE INTEGREE DE PUCES DE CIRCUIT INTEGRE

(30) Priority: 15.05.1992 US 884660
(43) Date of publication of application: 11.05.1994
(73) Proprietor: IRVINE SENSORS CORPORATION, Costa Mesa, CA 92626 (US)
(72) Inventor: MIYAKE, Michael, K., Westminster, CA 92683 (US)
(74) Representative: Baillie, Iain Cameron
(86) International application number: PCT/US93/04462
(87) International publication number: WO 93/23873

(56) References cited:
- WO-A-85/02283
- US-A- 4 897 708
- US-A- 4 983 533
- US-A- 5 016 138

## Description

### Background of the Invention

This invention relates to the fabrication of three-dimensional electronic packages in which a multiplicity of individual integrated circuit (IC) chips are secured together in a stack which provides a very high density electronic package.

The assignee of this application pioneered the use of IC chip stacks, first as modules providing photo-detector focal plane circuitry, and then as units suitable for computer memories and the like. US Patents 4,525,921 and 4,646,128 relate to the stacks designed for general use as memory devices and other non-focal-plane packages.

The methods used for fabricating such three dimensional (3D) IC chip stacks have become increasingly sophisticated. The three dimensional approach has been applied to both SRAM and DRAM memory chips with satisfactory results. Stacking of memory chips has reached density levels of seventy chips in a 0.56 cm x 1.32 cm x 1.32 cm (.220 inch x .520 inch x .520 inch) stack, each chip having a 1 megabit memory.

One problem, which applies to stacks used as memory devices and also to other non-focal-plane packages, is the difficulty of connecting exterior circuitry to the large number of conductors on the access plane of the completed stack. Focal plane chip stack modules incorporate multiplexer circuitry, which greatly reduces the number of module output connections. However, providing output connections for memory devices is a much greater challenge.

There are two acknowledged orientations which represent the structural relationship of the stacked IC chips in a module to the lead-out plate, or substrate, which makes outside electrical circuitry available for connection to the multiplicity of electrical leads (terminals) which are formed on the access plane face of the module, and which lead to the IC circuitry embedded in the module. In one arrangement, the layers of the module extend in planes perpendicular to the plane of the lead-out plate, or substrate. And in the other arrangement, the layers of the module extend in planes parallel to the plane of the lead-out plate, or substrate.

The lead-out plates, or substrates, may be located below, above, or along the side of, the stacked chip module. The two most common structures are described as a "sliced bread" stack, or as a "pancake" stack. Common assignee Patent No. 4,706,166 discloses a "sliced bread" stack, in which the IC chips in the stacked module are in planes perpendicular to a stack-supporting substrate. The substrate carries electrical conductors, which lead to external circuitry. The access plane of the stack faces the supporting substrate. And the electrical connections between the stack face and substrate are formed by bonding aligned solder bumps on the facing surfaces, a process which may be referred to as surface mount technology. In such a construction, the lead-out terminals are necessarily located very close to one another, a fact which creates difficulties in obtaining satisfactory lead-out connections.

"Pancake" stacks comprise IC chips which are in planes parallel to a supporting substrate. The electrical leads from the many terminals on the access plane of the stack preferably are brought either to the bottom or to the top of the stack, in order to be connected to external circuitry. Such "pancake" stacks are disclosed in a copending common assignee application. "Pancake" stacks, as distinguished from "sliced bread" stacks, are more likely to be used where a smaller number of IC chips are included in the stacked layer module, either because fewer chips are needed for a particular module, or because of limited "headroom", i.e., limited available space in which the module is located.

U.S. Patent No. 5,016,138 discloses a three-dimensional density package for integrated circuits for which integrated circuits are placed onto substrate layers and then stacked together.

U.S. Patent No. 4,983,533 discloses a high-density electronic module, which is suitable for use as a DRAM, SRAM, ROM, logic unit, or arithmetic unit. The module is formed by stacking integrated-circuit chips, each of which carries integrated circuitry. The chips are glued together, with their leads along one edge, so that all the leads of the stack are exposed on an access plane. Bonding bumps are formed at appropriate points on the access plane. A stack-supporting substrate is provided with suitable circuitry and bonding bumps on its face.

The present invention deals primarily with the problem of connecting the circuitry of IC chips in pancake stacks with suitable lead-out terminals, which are used in connecting to external circuitry.

### Summary of the Invention

This invention utilizes a non-conducting end, or cap, layer, which is an integral part of the stack, and which provides means for interconnecting the circuitry inside the stack with exterior circuitry. A significant result of this invention is a major increase in the real estate available for locating lead-out terminals.

The inner, non-exposed surface of the cap layer carries electrical lines (traces) which lead from metalization formed on the face of the stack to openings extending through the cap layer. Such openings provide conductive paths to the outer, exposed surface of the cap layer, where terminals are formed to connect to exterior circuitry.

A cap layer can be used as the top layer of the stack, the bottom layer of the stack, or as both the top and bottom layers of the stack. The cap is an insulated layer, which may be formed of dielectric material, or may be covered with dielectric material. The preferred cap layer is formed of dielectric material having a thermal expansion coefficient similar to that of the semiconductor material which constitutes the IC chip layers of the stack.

The invention includes an integrated stack of layers which form a rectangular parellelepiped having a first end face, a second end face, and four side faces, wherein the first end face is parallel to the second end face, wherein one of the side faces is an access plane, wherein the stack of layers contains embedded integrated circuitry (IC), wherein the layers of the stack include a plurality of IC chip layers provided by IC chips, wherein each IC chip has a first major end surface, a second major end surface, and four side surfaces, wherein the access plane comprises one side surface from each of the IC chips, and wherein each IC chip layer has a multiplicity of electrical leads at the access plane; wherein the layers of the stack include a first cap layer defining the first end face of the stack, wherein the first cap layer adjoins only one of the IC chip layers, the first cap layer being formed of a dielectric material and having an inner surface and an outer surface, the first cap layer having a plurality of holes extending between the inner surface and the outer surface; wherein the first cap layer has a plurality of traces on the inner surface, each trace leading from one of the holes to the access plane; wherein the outer surface of the first cap layer has a plurality of terminals, each terminal being located at one of the holes; wherein conducting material extends through each hole to connect the trace to the terminal; and wherein conducting material on the access plane connects each trace to an electrical lead on one or more IC chip layers.

The invention also includes a method of fabricating an electronic package, the method comprising: stacking a plurality IC chips to form a stack of IC chip layers, each IC chip having a first major end surface, a second major end surface, and four side surfaces, each IC chip having embedded IC circuitry and leads which extend to one of the side surfaces of the IC chip, wherein an access plane comprises one lead-carrying side surface from each of the IC chips; forming a first cap layer of dielectric material, the first cap layer having a flat inner surface and a flat outer surface; forming holes extending between the inner surface and the outer surface of the first cap layer; forming conductors on the inner surface of the first cap layer, each conductor connecting one of the holes to the access plane; forming terminals on the outer surface of the first cap layer, each terminal being located at one of the holes; forming conductors which extend through the holes in the first cap layer, in order to provide continuous electrical conduction from each terminal to the access plane; adding the first cap layer to the stack of IC chip layers; and forming an integrated stack of layers which includes the IC chip layers and the first cap layer, wherein the first cap layer adjoins only one of the IC chip layers, wherein the integrated stack of layers forms a rectangular parellelepiped having a first end face, a second end face, and four side faces, wherein the first end face is parallel to the second end face, and wherein one of the side faces comprises the access plane.

### Brief Description of the Drawings

Figure 1 is a front view of the access plane of a large stack of layers, containing a plurality of small stacks, each of which includes a cap layer and a plurality of IC chip layers;
Figure 2 is an isometric view of a short stack, which has been separated from the large stack shown in Figure 1;
Figure 3 is a close-up of the metalization at the center of the short stack in Figure 2;
Figure 4 is a plan view of the inner surface of the cap layer;
Figure 5 is a plan view of the outer surface of the cap layer; and
Figure 6 is a cross-section through the cap layer showing the metalization in the holes which extend through the cap layer.

### Detailed Description of Preferred Embodiment

The present invention is relevant to either large stacks of chips, or small stacks of chips. However, large stacks are more likely to be mounted in the "sliced bread" configuration than in the "pancake" configuration. Although small stacks might be individually fabricated, they normally will be fabricated by segmenting large stacks. The copending application is directed to the method of forming small stacks by creating a large stack, processing the access plane surface of the large stack, and then segmenting the large stack into a plurality of smaller stacks.

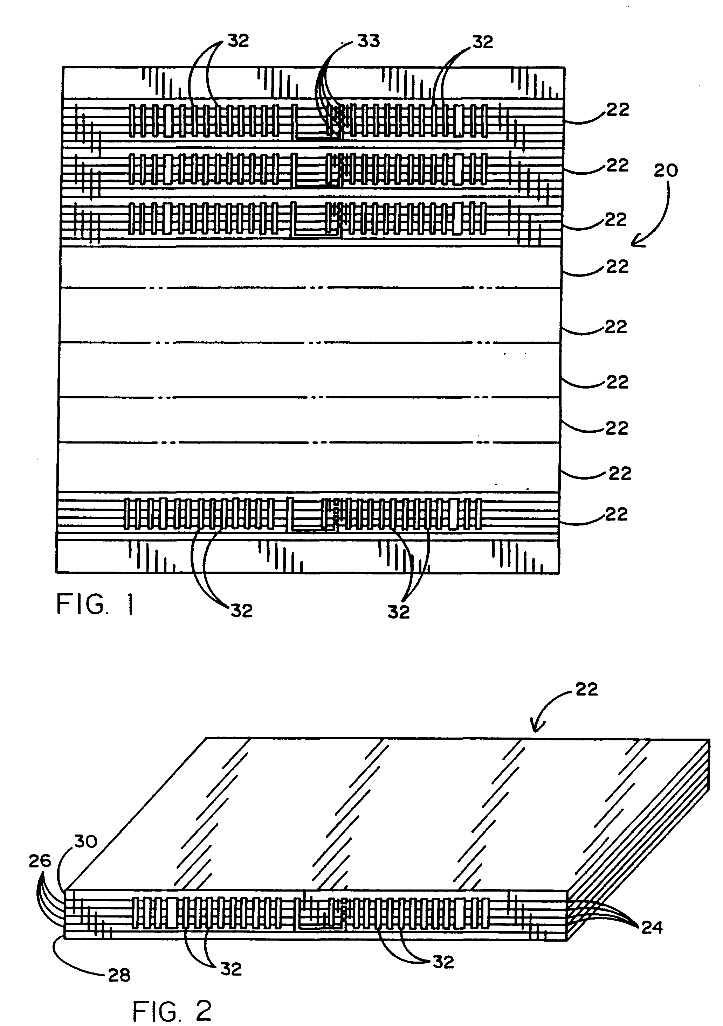

In Figure 1, a large stack 20 has been prepared and processed, and is ready for segmentation. A separation tool is used on the large stack 20 to remove the short stack 22 shown in Figure 2. The front plane of the stacks, as seen in Figures 1 and 2, is the access plane used for connection to external circuitry.

The short stack in Figure 2 has the shape of a rectangular parallelepiped. It contains four lead-carrying surfaces 24 formed on four active (IC) chip layers 26. Two inactive layers 28 and 30 are located at the bottom and top, respectively, of the short stack. They allow the active layers to be isolated from exterior circuitry, except for the metalization formed on the access plane. A reason for using inactive end layers is to permit T-connect engagement between each lead from the interior of the stack and metalization formed on the access plane of the stack.

The large stack 20 in Figure 1 provides 9 short stacks 22, each having four active chips. The number of chips in the large stack and in the small stack can be varied to suit particular stack fabrication needs. It is assumed, however, that each of the multiple short stacks formed from a given large stack will normally be identical in size.

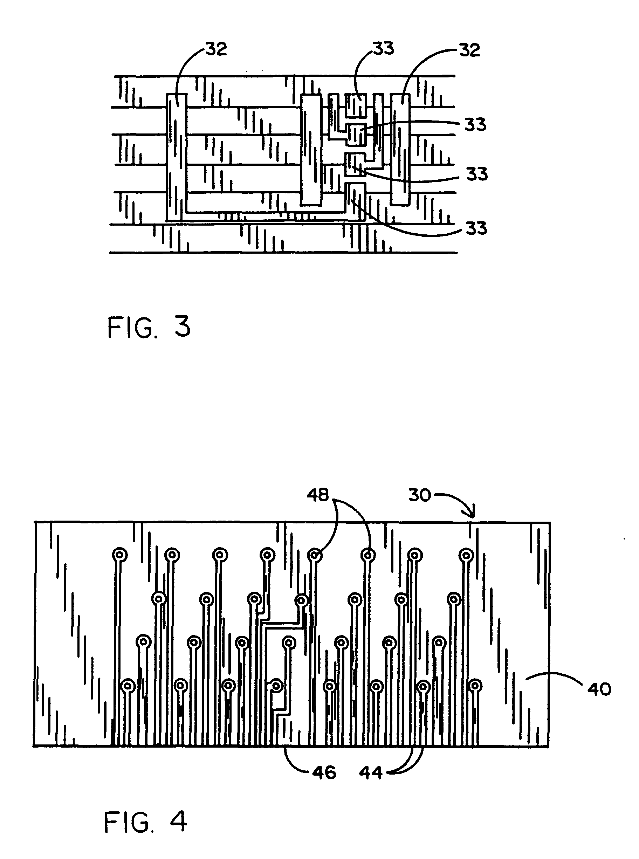

As seen in Figures 1 and 2, the access plane of the large and small stacks has electrically conductive metalization formed thereon, in the form of numerous vertically extending buses 32, and pads 33 permitting separate access to each chip. These buses and pads are electrically connected to the circuitry embedded in the stacks, by means of a multiplicity of T-connects of the type disclosed in prior common assignee patents and applications. The term "T-connect" means that each flat lead coming from the IC portion of the layer to the layer edge is in electrical contact with a metal strip or pad which extends beyond the lead in both directions (both upwardly and downwardly in Figures 1-3). Experience has demonstrated the value of T-connects where the more common techniques of solder bonding are not feasible. Note that the T-connect metalization strips extend onto the lower portion of the top (inactive) layer 30.

Stacks of layers which include active IC chip layers, and also inactive end layers, are assembled in a stacking fixture, with a thin layer of adhesive placed between adjacent layers. The stacked layers and fixture are then placed in an oven and baked at the curing temperature for a given time. The "face" of the stack is sanded and lapped, then plasma etched to expose the metal leads on each active chip. The leads are of the order of 1 micrometer thick and 125 micrometers wide. After sufficient etching, several layers of polyimide are deposited over the stack face, covering to a depth somewhat greater than the length of the exposed metal leads. This polyimide serves as a passivating layer between the silicon chips and the metal pads/buslines deposited later in the process. After curing the polyimide layers, the face of the stack is thinly lapped to clear cured polyimide from the metal lead ends.

Using photolithography (either lift-off or etchback) and sputter deposition of metal, the pads and buslines are formed on the stack face. The metal lead interconnects that are formed are preferably T-connects.

In order to segment the large stack shown in Figure 1 into a plurality of the small stacks shown in Figure 2, means must be devised to divide the full stack into several short stacks. This has been accomplished using a thermoplastic adhesive on the plane between the short stacks, heating to the adhesive's softening temperature, and applying a shear force to slide one short stack off another. The adhesive bonding of the layers within the short stack is of course still rigid and unaffected by the shear force.

In the short stack of Figure 2, the four active chip layers 26 are usually formed of silicon, which is a semiconductor material. The inactive upper layer, or cap, 30 is preferably formed of a non-conducting (dielectric) material. If desired, the bottom layer 28 may also be formed of the same non-conducting (dielectric) material. The cap layer 30 could be formed of the same material as that of the IC chips, and then covered with insulating material. The advantage of such an insulation-covered silicon layer would be an identical coefficient of thermal expansion (CTE). However, it is considered preferable to use a dielectric material as the cap layer 30, selecting a material which has a CTE very similar to that to which of the IC chip material. Having similar CTE values is very important in avoiding stresses due to temperature variations to which the stacked layer module is subjected.

The preferred material for cap layer 30 is aluminum nitride, which has a CTE of 4.6 ppm. This is close to the CTE of the semiconductor silicon, which is generally used as the IC chip material. The CTE of silicon is approximately 4.0 ppm. Aluminum nitride also provides good mechanical strength, and it is available in the desired layer thickness.

Because the aluminum nitride (ceramic) cap layer is an integral part of the stacked layer module, it is necessary to pre-form that layer, and to pre-process the circuitry on that layer, before it is inserted into the stack, which thereafter is integrated and then subjected to various processing steps.

The interconnection between the internal short stack circuitry (IC chips) and the external circuitry is made through the cap layer 30, starting with T-connects on the edge of the inner (lower) surface of the cap layer. These T-connects join the buses 32 and pads 33 to lead lines (traces) formed on the inner surface of the cap layer.

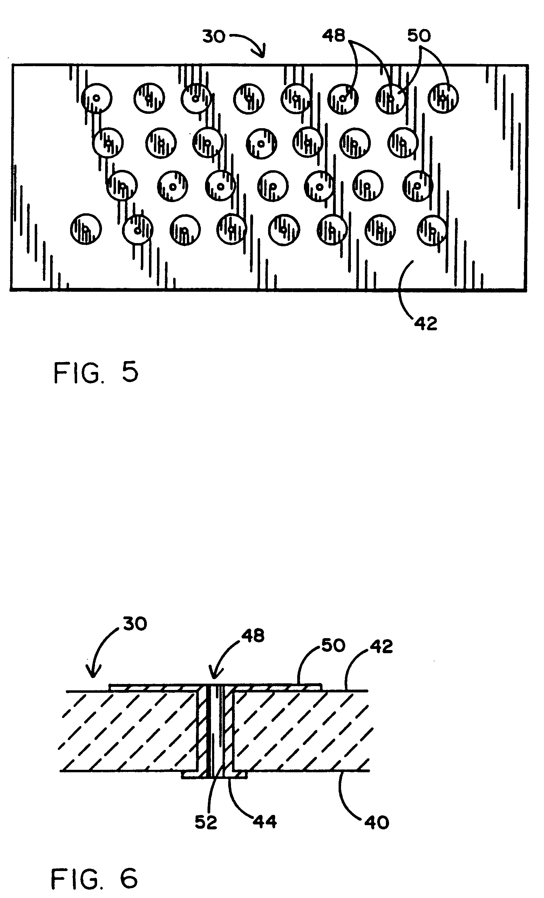

Figure 4 shows the inner surface 40 of cap layer 30; and Figure 5 shows the outer surface 42 of cap layer 30. Parallel traces, or conductors, 44 on inner surface 40 each extend from edge 46, where the T-connects are formed, to one of the holes 48, which extend through to the outer surface 42. On outer surface 42, each hole 48 is surrounded by a terminal pad 50, which will be subsequently connected to exterior circuitry, e.g., by wire bonding.

A significant advantage of the present invention is the substantial increase in real estate available for the lead-out terminals 50. The entire area of outer surface 42 of layer 30 is available for spacing the locations of the terminals. This means that lead-out connections, such as wire bonds, can be readily formed, without risk of creating any short circuits.

Conductive connections through the holes 48 are provided by material, preferably metal, which is suitably deposited in the holes. This material must maintain electrical continuity between pads 50 and traces 44, regardless of thermal changes or other stresses. The presently preferred method of providing the conductors 52 (see Figure 6) which extend through the holes 48 is by deposition of a suitable metal on the inner walls of the holes.

Providing continuous electrical conduction from the access plane T-connects, along the traces 44, and along the conductors 52 in holes 48, to the exterior terminals 50, may be accomplished by any suitable method. One such method is electroplating. Assuming top layer 30 is formed of aluminum nitride (a ceramic), a preliminary "electroless" process must be performed, in order to form a very thin metallic "seeding" layer on the ceramic material. The seeded metal is then available as the cathode in an electroplating (electrolytic) process which is used to thicken the metal conductors to the desired extent. The traces 44, the metal conductors on the walls of holes 48, and the pads 50, may be simultaneously formed by the seeding and electroplating steps.

Another possible method for providing the continuous electrical conduction on and through layer 30 is metal sputtering. That process is feasible if the layer 30 is thin enough and if the holes 48 are large enough. Before sputtering on the primary conducting metal, such as gold or copper, an adhesion metal layer, such as titanium-tungsten would be sputtered on the dielectric surface. Yet another possibility would be fieling the holes 48 with conducting material.

As previously stated, the use of holes 48, combined with traces 44, permits the access plane connections to be T-connects, which are considered preferable as reliable conductor intersections. However, it would be possible to extend the metalization strips on the access plane of the stack to the outer surface 42 of cap layer 30, and then use wrap-around connections leading directly to traces on the outer surface 42, thereby eliminating the need for holes 48. Such an electrical conduction method would retain the important real estate advantage of the present invention, in which the full area of outer surface 42 is available for locating lead-out terminals.

If the surface having the lead-out terminals 50 is exposed, as it is on the top of the pancake stack shown in Figure 2, access of external circuitry to the pads 50 is easily obtained, e.g., by wire bonding. If external circuitry is to be connected at the bottom of the stack, surface mount technology, such as direct solder bonding, may be used, similar to that of US Patent No. 4,706,166. Lead-out conductors could be provided at both the top and bottom cap layers. Forming lead-out terminals on the non-exposed end surface of the stack would have the same real estate advantage as forming such terminals on the exposed surface.

Even where the exterior circuitry access is solely at the top of the stack, it may be desirable to use a ceramic layer also as the bottom layer of the stacked chip module. One of the process steps performed on the large stack is etching to remove some silicon semiconductor material from the access plane, prior to passivating the access plane with a material such as polyimide. The silicon etching process does not significantly etch the aluminum nitride material. If aluminum nitride layers are located at both the top and bottom of each short stack, a symmetrical access plane surface will remain after the etching process. Another advantage might result from the fact that separation of adjacent small stacks from a large stack would involve separation of layers formed of the same material. It should be understood that the ceramic layer or layers will not project from the access plane of the stack at the time of forming the metalization thereon, because of the planarization of the access plane accomplished by the final lapping process.

From the foregoing description, it will be apparent that the method and structure disclosed in this application will provide the significant functional benefits summarized in the introductory portion of the specification.

## Claims

1. An integrated stack (20 or 22) of layers which form a rectangular parallelepiped having a first end face, a second end face, and four side faces, wherein the first end face is parallel to the second end face, wherein one of the side faces is an access plane, wherein the stack (20 or 22) of layers contains embedded integrated circuitry (IC),
wherein the layers of the stack (20 or 22) include a plurality of IC chip layers (26) provided by IC chips, wherein each IC chip has a first major end surface, a second major end surface, and four side surfaces, wherein the access plane comprises one side surface (24) from each of the IC chips, and wherein each IC chip layer (26) has a multiplicity of electrical leads (32 or 33) at the access plane;
wherein the layers of the stack (20 or 22) include a first cap layer (30) defining the first end face of the stack (20 or 22), wherein the first cap layer (30) adjoins only one of the IC chip layers (26), the first cap layer (30) being formed of a dielectric material and having an inner surface (40) and an outer surface (42), the first cap layer (30) having a plurality of holes (48) extending between the inner surface (40) and the outer surface (42);
wherein the first cap layer (30) has a plurality of traces (44) on the inner surface (40), each trace leading from one of the holes (48) to the access plane;
wherein the outer surface (42) of the first cap layer (30) has a plurality of terminals (50), each terminal (50) being located at one of the holes (48);
wherein conducting material (52) extends through each hole (48) to connect the trace (44) to the terminal (50); and
wherein conducting material (32 or 33) on the access plane connects each trace (44) to an electrical lead on one or more IC chip layers (26).

2. The integrated stack (20 or 22) of layers of claim 1, in which the IC chip layers (26) are formed from a material having a coefficient of thermal expansion, and the dielectric material of the first cap layer (30) has a coefficient of thermal expansion similar to the coefficient of thermal expansion of the material which forms the IC chip layers (26).

3. The integrated stack (20 or 22) of layers of claim 2, in which the material forming the IC chip layers (26) is silicon, and the material forming the first cap layer (30) is aluminum nitride.

4. The integrated stack (20 or 22) of layers of any of the preceding claims,
wherein the layers of the stack (20 or 22) include a second cap layer (28) defining the second end face of the stack (20 or 22), the second cap layer (28) being formed of a dielectric material.

5. A method of fabricating an electronic package, the method comprising:
stacking a plurality IC chips to form a stack (20 or 22) of IC chip layers (26), each IC chip having a first major end surface, a second major end surface, and four side surfaces, each IC chip having embedded IC circuitry and leads which extend to one of the side surfaces (24) of the IC chip, wherein an access plane comprises one lead-carrying side surface (24) from each of the IC chips;
forming a first cap layer (30) of dielectric material, the first cap layer (30) having a flat inner surface (40) and a flat outer surface (42);
forming holes (48) extending between the inner surface (40) and the outer surface (42) of the first cap layer (30);
forming conductors (44) on the inner surface (40) of the first cap layer (30), each conductor connecting one of the holes (48) to the access plane;
forming terminals (50) on the outer surface (42) of the first cap layer (30), each terminal (50) being located at one of the holes (48);
forming conductors (52) which extend through the holes (48) in the first cap layer (30), in order to provide continuous electrical conduction from each terminal (50) to the access plane;
adding the first cap layer (30) to the stack (20 or 22) of IC chip layers (26); and
forming an integrated stack (20 or 22) of layers which includes the IC chip layers (26) and the first cap layer (30), wherein the first cap layer (30) adjoins only one of the IC chip layers (26), wherein the integrated stack (20 or 22) of layers forms a rectangular parallelepiped having a first end face, a second end face, and four side faces, wherein the first end face is parallel to the second end face, and wherein one of the side faces comprises the access plane.

6. The method of claim 5 in which the step of forming an integrated stack (20 or 22) of layers includes adhesively bonding adjacent layers together.

7. The method of fabricating an electronic package having an integrated stack (20 or 22) of layers as claimed in claim 5 or 6, in which:
continuous metalization is provided by each trace (44), its through-the-hole conducting material (52), and its terminal (50); and
such continuous metalization is formed on the first cap layer (30) by means of an electroplating process.

8. The method of fabricating an electronic package having an integrated stack (20 or 22) of layers as claimed in claim 7, in which the electroplating process comprises:
electroless forming of a thin metallic seeding layer on the dielectric material of the first cap layer (30); and
a subsequent electrolytic plating to bring the metalization to a desired thickness.

## Patentansprüche

1. Integrierter Stapel (20 oder 22) aus Schichten, die ein rechteckiges Parallelepipedon mit einer ersten Stirnfläche, einer zweiten Stirnfläche und vier Seitenflächen bilden, wobei die erste Stirnfläche parallel zu der zweiten Stirnfläche ist, wobei eine der Seitenflächen eine Zugangsebene aufweist, wobei der Stapel (20 oder 22) aus Schichten einen eingebetteten integrierten Schaltkreis (IC) aufweist;
wobei die Schichten des Stapels(20 oder 22) eine Mehrzahl von IC-Chip-Schichten (26) aufweisen, die durch IC-Chips vorgesehen werden, wobei jeder IC-Chip eine erste Hauptstirnfläche, eine zweite Hauptstirnfläche und vier Seitenflächen aufweist, wobei die Zugangsebene eine Seitenoberfläche (24) von jedem der IC-Chips aufweist, und wobei jede IC-Chip-Schicht (26) eine Mehrzahl elektrischer Zuleitungen (32 oder 33) auf der Zugangsebene aufweist;
wobei die Schichten des Stapels (20 oder 22) eine erste Abdeckschicht (30) aufweisen, welche die erste Stirnfläche des Stapels (20 oder 22) definiert, wobei die erste Abdeckschicht (30) nur an eine der IC-Chip-Schichten (26) angrenzt, wobei die erste Abdeckschicht (30) aus einem dielektrischen Werkstoff hergestellt wird und eine Innenoberfläche (40) und eine Außenoberfläche (42) aufweist, wobei die erste Abdeckschicht (30) eine Mehrzahl von Öffnungen (48) aufweist, die sich zwischen der Innenoberfläche (40) und der Außenoberfläche (42) erstrecken;
wobei die erste Abdeckschicht (30) eine Mehrzahl von Spuren (44) auf der Innenoberfläche (40) aufweist, wobei jede Spur von einer der Öffnungen (48) zu der Zugangsebene führt;
wobei die Außenoberfläche (42) der ersten Abdeckschicht (30) eine Mehrzahl von Anschlüssen (50) aufweist, wobei jeder Anschluss (50) an einer der Öffnungen (48) angeordnet ist;
wobei sich leitfähiges Material (52) durch jede Öffnung (48) erstreckt, so dass die Spur (44) mit dem Anschluss (50) verbunden wird; und
wobei leitfähiges Material (32 oder 33) auf der Zugangsebene jede Spur (44) mit einer elektrischen Zuleitung an einer oder mehreren IC-Chip-Schichten (26) verbindet.

2. Integrierter Stapel (20 oder 22) aus Schichten nach Anspruch 1, wobei die IC-Chip-Schichten (26) aus einem Material mit einem thermischen Volumenausdehnungskoeffizienten gebildet werden, und wobei das dielektrische Material der ersten Abdeckschicht (30) einen thermischen Volumenausdehnungskoeffizienten aufweist, der dem thermischen Volumenausdehnungskoeffizienten des Materials entspricht, das die IC-Chip-Schichten (26) bildet.

3. Integrierter Stapel (20 oder 22) aus Schichten nach Anspruch 2, wobei es sich bei dem Material, aus dem die IC-Chip-Schichten (26) gebildet werden, um Silizium handelt, und wobei es sich bei dem Material, aus dem die erste Abdeckschicht (30) gebildet wird, um Aluminiumnitrid handelt.

4. Integrierter Stapel (20 oder 22) aus Schichten nach einem der vorstehenden Ansprüche,
wobei die Schichten des Stapels (20 oder 22) eine zweite Abdeckschicht (28) aufweisen, welche die zweite Stirnfläche des Stapels (20 oder 22) definieren, wobei die zweite Abdeckschicht (28) aus einem dielektrischen Material gebildet wird.

5. Verfahren zur Herstellung eines elektronischen Pakets, wobei das Verfahren die folgenden Schritte umfasst:
Stapeln einer Mehrzahl von IC-Chips zur Bildung eines Stapels (20 oder 22) aus IC-Chip-Schichten (26), wobei jeder IC-Chip eine erste Hauptstirnfläche, eine zweite Hauptstirnfläche und vier Seitenflächen aufweist, wobei jeder IC-Chip einen eingebetteten IC-Schaltkreis und Zuleitungen aufweist, die sich zu einer der Seitenflächen (24) des IC-Chips erstrecken, wobei eine Zugangsebene eine Zuleitungen tragende Seitenfläche (24) von jedem der IC-Chips aufweist;
Bilden einer ersten Abdeckschicht (30) aus dielektrischem Material, wobei die erste Abdeckschicht (30) eine flache Innenoberfläche (40) und eine flache Außenoberfläche (42) aufweist;
Bilden von Öffnungen (48), die sich zwischen der Innenfläche (40) und der Außenfläche (42) der ersten Abdeckschicht (30) erstrecken;
Bilden von Leitern (44) auf der Innenfläche (40) der ersten Abdeckschicht (30), wobei jeder Leiter eine der Öffnungen (48) mit der Zugangsebene verbindet;
Bilden von Anschlüssen (50) auf der Außenfläche (42) der ersten Abdeckschicht (30), wobei jeder Anschluss (50) an einer der Öffnungen (48) angeordnet ist;
Bilden von Leitern (52), die sich durch die Öffnungen (48) in der ersten Abdeckschicht (30) erstrecken, so dass eine ununterbrochene elektrische Leitfähigkeit von jedem Anschluss (50) zu der Zugangsebene vorgesehen wird;
Hinzufügen der ersten Abdeckschicht (30) zu dem Stapel (20 oder 22) der IC-Chip-Schichen (26); und
Bilden eines integrierten Stapels (20 oder 22) aus Schichten, der die IC-Chip-Schichten (26) und die erste Abdeckschicht (30) aufweist, wobei die erste Abdeckschicht (30) nur an eine der IC-Chip-Schichten (26) angrenzt, wobei der integrierte Stapel (20 oder 22) von Schichten ein rechteckiges Parallelepipedon mit einer ersten Stirnfläche, einer zweiten Stirnfläche und vier Seitenflächen bildet, wobei die erste Stirnfläche parallel zu der zweiten Stirnfläche ist, und wobei eine der Seitenflächen die Zugangsebene umfasst.

6. Verfahren nach Anspruch 5, wobei der Schritt des Bildens eines integrierten Stapels (20 oder 22) aus Schichten die Verbindung angrenzender Schichten durch Adhäsion umfasst.

7. Verfahren zur Herstellung eines elektronischen Pakets mit einem integrierten Stapel (20 oder 22) aus Schichen nach Anspruch 5 oder 6, wobei:
eine kontinuierliche Metallisierung durch jede Spur (44), deren Durchkontaktierungsmaterial (52) und deren Anschluss (50) vorgesehen wird; und
wobei die kontinuierliche Metallisierung auf der ersten Abdeckschicht (30) durch ein Elektroplattierungsverfahren gebildet wird.

8. Verfahren zur Herstellung eines elektronischen Pakets mit einem integrierten Stapel (20 oder 22) aus Schichen nach Anspruch 7, wobei das Elektroplattierungsverfahren folgendes umfasst:
stromloses Bilden einer dünnen Seeding-Schicht aus Metall auf dem dielektrischen Material der ersten Abdeckschicht (30); und
folgendes elektrolytisches Plattieren, so dass die Metallisierung in der gewünschten Dicke vorgesehen wird.

## Revendications

1. Pile intégrée (20 ou 22) de couches formant un parallélépipède rectangle ayant une première face d'extrémité, une seconde face d'extrémité et quatre faces latérales, dans laquelle la première face d'extrémité est parallèle à la seconde face d'extrémité, dans laquelle l'une des faces latérales est un plan d'accès, dans laquelle la pile (20 ou 22) de couches contient des circuits intégrés incorporés (CI),
dans laquelle les couches de la pile (20 ou 22) comportent un ensemble de couches de puces de CI (26) constituées par des puces de CI, dans laquelle chaque puce de CI possède une première surface d'extrémité principale, une seconde surface d'extrémité principale et quatre surfaces latérales, dans laquelle le plan d'accès comprend une surface latérale (24) de chacune des puces de CI et dans laquelle chaque couche de puces de CI (26) comporte une multiplicité de conducteurs électriques (32 ou 33) au niveau du plan d'accès ;
dans laquelle les couches de la pile (20 ou 22) comportent une première couche de recouvrement (30) définissant la première face d'extrémité de la pile (20 ou 22) dans laquelle la première couche de recouvrement (30) est attenante à une seule des couches de puces de CI (26), la première couche de recouvrement (30) étant formée d'un matériau diélectrique et ayant une surface interne (40) et une surface externe (42), la première couche de recouvrement (30) comportant un ensemble de trous (48) s'étendant entre la surface interne (40) et la surface externe (42) ;
dans laquelle la première couche de recouvrement (30) comporte un ensemble de pistes (44) sur la surface interne (40), chaque piste conduisant de l'un des trous (48) au plan d'accès ;
dans laquelle la surface externe (42) de la première couche de recouvrement (30) comporte un ensemble de bornes (50), chaque borne (50) étant située au niveau de l'un des trous (48) ;
dans laquelle le matériau conducteur (52) s'étend à travers chaque trou (48) pour relier la piste (44) à la borne (50) ; et
dans laquelle le matériau conducteur (32 ou 33) sur le plan d'accès relie chaque piste (44) à un conducteur électrique sur une ou plusieurs couches de puces de CI (26).

2. Pile intégrée (20 ou 22) de couches selon la revendication 1, dans laquelle les couches de puces de CI (26) sont formées d'un matériau ayant un certain coefficient de dilatation thermique et le matériau diélectrique de la première couche de recouvrement (30) a un coefficient de dilatation thermique similaire au coefficient de dilatation thermique du matériau qui constitue les couches de puces de CI (26).

3. Pile intégrée (20 ou 22) de couches selon la revendication 2, dans laquelle le matériau constituant les couches de puces de CI (26) est du silicium et le matériau constituant la première couche de recouvrement (30) est du nitrure d'aluminium.

4. Pile intégrée (20 ou 22) de couches selon l'une quelconque des revendications précédentes,
dans laquelle les couches de la pile (20 ou 22) comportent une seconde couche de recouvrement (28) définissant la seconde face d'extrémité de la pile (20 ou 22), la seconde couche de recouvrement (28) étant formée d'un matériau diélectrique.

5. Procédé de fabrication d'un boîtier électronique, le procédé comprenant :
l'empilement d'un ensemble de puces de CI pour former une pile (20 ou 22) de couches de puces de CI (26), chaque puce de CI ayant une première surface d'extrémité principale, une seconde surface d'extrémité principale et quatre surfaces latérales, chaque puce de CI comportant des circuits CI incorporés et des conducteurs qui s'étendent vers l'une des surfaces latérales (24) de la puce de CI, dans lequel un plan d'accès comprend une surface latérale porteuse de conducteurs (24) de chacune des puces de CI ;
la formation d'une première couche de recouvrement (30) de matériau diélectrique, la première couche de recouvrement (30) ayant une surface interne plate (40) et une surface externe plate (42) ;
la formation de trous (48) s'étendant entre la surface interne (40) et la surface externe (42) de la première couche de recouvrement (30) ;
la formation de conducteurs (44) sur la surface interne (40) de la première couche de recouvrement (30), chaque conducteur reliant l'un des trous (48) au plan d'accès ;
la formation de bornes (50) sur la surface externe (42) de la première couche de recouvrement (30), chaque borne (50) étant située au niveau de l'un des trous (48) ;
la formation de conducteurs (52) s'étendant à travers les trous (48) dans la première couche de recouvrement (30), pour fournir une conduction électrique continue de chaque borne (50) au plan d'accès ;
l'addition de la première couche de recouvrement (30) à la pile (20 ou 22) des couches de puces de CI (26) ; et
la formation d'une pile intégrée (20 ou 22) de couches qui comporte les couches de puces de CI (26) et la première couche de recouvrement (30), dans lequel la première couche de recouvrement (30) est attenante à une seule des couches de puces de CI (26), dans lequel la pile intégrée (20 ou 22) de couches forme un parallélépipède rectangle ayant une première face d'extrémité, une seconde face d'extrémité et quatre faces latérales, dans lequel la première face d'extrémité est parallèle à la seconde face d'extrémité et dans lequel l'une des faces latérales comprend le plan d'accès.

6. Procédé selon la revendication 5, dans lequel l'étape de formation d'une pile intégrée (20 ou 22) de couches comporte la liaison de couches adjacentes d'une manière adhésive.

7. Procédé de fabrication d'un boîtier électronique comportant une pile intégrée (20 ou 22) de couches selon la revendication 5 ou 6, dans lequel :
une métallisation continue est constituée par chaque piste (44), son matériau conducteur de traversée de trou (52) et sa borne (50) ; et
cette métallisation continue est formée sur la première couche de recouvrement (30) au moyen d'un processus d'électrodéposition.

8. Procédé de fabrication d'un boîtier électronique comportant une pile intégrée (20 ou 22) de couches selon la revendication 7, dans lequel le processus d'électrodéposition comprend :
la formation sans électrode d'une couche d'amorçage métallique mince sur le matériau diélectrique de la première couche de recouvrement (30) ; et
un dépôt électrolytique y faisant suite, pour amener la métallisation à une épaisseur désirée.
